# EUROPÄISCHE PATENTSCHRIFT

(11) **EP 1 932 405 B1**
(45) Veröffentlichungstag und Bekanntmachung des Hinweises auf die Patenterteilung: **28.09.2016**
(21) Anmeldenummer: 06763849.4
(22) Anmeldetag: 22.06.2006
(51) Int. Cl.: H05K 5/06

(54) **GEHÄUSESYSTEM FÜR ELEKTRONIKGERÄTE**
HOUSING SYSTEM FOR ELECTRONIC DEVICES
SYSTEME DE BOITIER POUR APPAREILS ELECTRONIQUES

(30) Priorität: 16.08.2005 DE 102005038687
(43) Veröffentlichungstag der Anmeldung: 18.06.2008
(73) Patentinhaber: Continental Automotive GmbH, 30165 Hannover (DE)
(72) Erfinder: JANISCH, Christian, 93133 Burglengenfeld (DE)
(86) Internationale Anmeldenummer: PCT/EP2006/063456
(87) Internationale Veröffentlichungsnummer: WO 2007/020122

(56) Entgegenhaltungen:
- DE-A1-102004 012 229
- DE-C1- 19 902 283
- JP-A- 58 125 851

## Beschreibung

Die Erfindung betrifft ein Gehäusesystem für Elektronikgeräte, insbesondere für den Automobilbereich, umfassend ein Gehäuseoberteil sowie ein Gehäuseunterteil.

Elektronikgehäuse erfüllen unterschiedliche Funktionen. Zum einen dienen sie dazu, verschiedenste Gegenstände wie zum Beispiel Leiterplatten, Spulen, Kondensatoren und ähnliches, aufzunehmen, um sie vor äußeren Einflüssen zu schützen, zum anderen ermöglichen sie eine möglichst feste Positionierung dieser konventionellen bzw. integrierten Bauelemente.

Im Automobilbereich hängen die Anforderungen an Elektronikgehäuse von der jeweiligen Positionierung des Gehäuses ab. Wird das Elektronikgerät am Motorblock oder direkt im Getriebe montiert, muss das Gehäuse anderen Ansprüchen gerecht werden als bei einem Einbau im Passagierraum. Für Elektronikgeräte, die im Bereich des Motorblocks angeordnet sind, ergeben sich hohe Belastungen hinsichtlich der Temperaturstabilität, der Vibration- und Stoßdämpfung und der Dichtheit gegen Spritzwasser, Öl und Salzsprühnebel. Daher werden oft gewisse mindest Anforderungen an die Dichtheit gestellt, so dass die Komponenten im Gehäuse nicht durch die äußeren Einflüsse beschädigt werden können. Auch müssen die Geräte den Temperaturen, die über längere Zeit auf sie einwirken, ohne Defekt standhalten. Weitere Anforderungen an Elektronikgeräte bestehen darin, dass sie auch ohne Defekt in Eiswasser tauchfähig sind und/oder.im Heißwasser-Dampfstrahl funktionsfähig bleiben. Des Weiteren haben Elektronikgehäuse eine Schutzfunktion vor Staub, Steinschlag, Ölen, Laugen, Säuren und Reinigungsmitteln.

Das aus dem Stand der Technik bisher bekannte Grunddesign für ein Elektronikgehäuse besteht aus einem Gehäuseboden und einem Deckel die mehr oder weniger stark als Wannen ausgeführt sind, um integrierte und/oder konventionelle Bauelemente aufzunehmen. Die Gehäuseteile werden aus verschiedenen Werkstoffen wie zum Beispiel aus Stahl- und Aluminiumblechen oder aus Kunststoffspritzteilen angefertigt und in Kombination miteinander eingesetzt. Zur Abdichtung des Elektronikgeräts gibt es verschiedene Möglichkeiten. Die Dichtung kann bereits am Gehäuseboden oder am Deckel angespritzt sein oder als Vergussvariante in der Endmontage gefertigt werden. Außerdem ist es auch möglich, gespritzte oder gestanzte Einlegedichtungen zu verwenden.

Auch die Verbindung der Gehäuseteile ist von den Anforderungen abhängig. Die Gehäuseteile können beispielsweise miteinander verschraubt, vernietet, geklipst, verrastet oder/und verriegelt werden. Durch die Temperaturschwankungen der Umgebung, die im Motorraum zwischen -40° C bis 170° C liegen, und durch die Eigenwärme der Elektronikelemente entsteht in den abgedichteten Gehäusen Unter- bzw. Überdruck. Zum Ausgleich dieser Druckschwankungen werden Druckausgleichselemente, die eine in beide Richtungen annähernd wasserundurchlässige, diffusionsoffene Membran aufweisen, in die Gehäusewand integriert, so dass das Dichtungssystem und die Gehäusekomponenten nicht beschädigt werden. Die im Druckausgleichselement benötigte Diffusionsoffenheit wird durch den jeweiligen benötigten Luftmengendurchsatz pro Zeiteinheit bestimmt. Nachteilig ist dabei jedoch, dass der Dichtheitsgrad des Elektronikgeräts unter anderem von dieser Diffusionsoffenheit des Druckausgleichelementes abhängig ist.

Hiervon ausgehend liegt der vorliegenden Erfindung die Aufgabe zugrunde, ein Gehäusesystem mit wenigstens einem Druckausgleichselement zu schaffen, dass leicht zu montieren ist und zugleich ein sicheres Dichtsystem bietet.

Diese Aufgabe wird durch ein Gehäusesystem für Elektronikgeräte mit den Merkmalen des Patentanspruchs 1 gelöst. Vorteilhafte Aus- und Weiterbildungen, welche einzeln oder in Kombination miteinander eingesetzt werden können, sind der Gegenstand der abhängigen Ansprüche.

Das erfindungsgemäße Gehäusesystem zeichnet sich dadurch aus, dass am Gehäuseunterteil eine Druckausgleichsfolie als Gehäuseoberteil befestigt ist. Die elastische Folie wird auf den Gehäusebodenrand dicht verklebt und verformt sich bei Änderungen des Gehäuseinnendrucks. Durch diese Verformung wird das Gehäuseinnenvolumen verändert und der Gehäuseinnendruck dem Außendruck angepasst. Es kommt zu einem Differenzdruckausgleich durch Volumenänderung.

Auf die Folienausdehnung kann über die Folienfläche, die Folienmaterialelastizität und die Oberflächengestaltung Einfluss genommen werden. Durch eine größere Folienfläche, die zudem auch sehr dehnbar ist, wird ein größeres Ausgleichsvolumen für den Druckausgleich ermöglicht, als bei einer nicht so dehnbaren kleineren Folienfläche. Zudem kann auch durch eine gestalterische Formgebung wie zum Beispiel durch Tiefziehen einer ringförmigen Faltenbalgmembram in die Folienfläche, eine Erhöhung des möglichen Ausgleichvolumens bewirkt werden. Eine andere Möglichkeit besteht in der Oberflächenprägung wie zum Beispiel bei Dekorflächen, unter Beibehaltung der Foliendicke.

Besonders vorteilhaft ist es, wenn die Druckausgleichsfolie aus einem temperaturstabilen Material gefertigt ist, da das erfindungsgemäße Gehäusesystem somit auch im Bereich des Motors, wo extreme Temperaturen erreicht werden, verbaut werden kann.

Vorteilhaft ist es zudem, wenn die Druckausgleichsfolie Haltelaschen aufweist, um die Haltekräfte der Verklebung zu erhöhen, so dass das Ablösen der Folie durch die durch Unter- bzw. Überdruck entstehende Zugkraft an der Folie verhindert wird. Bei diesen Folienlaschen besteht die Möglichkeit, eine Beschriftung anzubringen und die Laschen zur Teilekennzeichnung als Typenschilder zu verwenden.

Es ist des Weiteren bevorzugt, am Rand der Druckausgleichsfolie umlaufend einen geschlossenen Klebeflächenring anzuordnen, da so eine leichte Montage der Folie möglich ist und zudem ein sicheres Dichtsystem zwischen Gehäuseunterteil und Druckausgleichsfolie bereitgestellt wird, das darüber hinaus noch kostengünstig ist, da keine zusätzlichen Bauteile für die Dichtung benötigt werden.

Das erfindungsgemäße Gehäusesystem ermöglicht vorteilhaft eine zusätzliche Montage eines Schutzdeckels, der oberhalb der Druckausgleichsfolie am Gehäuseunterteil befestigt ist. Hierdurch wird die Folie vor mechanischen Einflüssen wie zum Beispiel Steinschlägen geschützt. Bei Bedarf kann dieser Schutzdeckel derart gestaltet sein, dass auf die Verklebung bzw. die Dichtfläche der Folie zusätzlich von außen auf das Dichtsystem gedrückt wird, wodurch insgesamt die Qualität der Abdichtung erhöht bzw. das Risiko für mögliche Undichtigkeit minimiert wird.

Um ein Reißen oder zu schnelles Altern der Folie bei Überbeanspruchung durch Überdehnung zu verhindern, können vorteilhaft sowohl am Gehäuseunterteil als auch am Schutzdeckel Begrenzungselemente als Wegbegrenzung für die Folie angebracht werden (z.B. Stege, Rippen, Dome).

Zudem besteht weiterhin die Möglichkeit, eine diffusionsoffene Druckausgleichsmembran für große Ausgleichsvolumina einzusetzen, die alleine durch die notwendige Diffusionsoffenheit für den Luftdurchsatz hinsichtlich der geforderten Dichtigkeit nicht ausreichend ist.

Die vorliegende Erfindung schafft erstmals vorteilhaft ein flexibles, individuell und damit variabel auf den Bauraum abstellbares Gehäusesystem mit in einem Druckausgleichselement integriertem Dichtsystem. Sie eignet sich insbesondere für Anwendungen im Automobilbereich.

Weitere Vorteile und Ausgestaltungen der Erfindung werden nachfolgend anhand eines Ausführungsbeispiels sowie anhand der Zeichnungen erläutert.

Dabei zeigen schematisch:
- Fig. 1: eine Explosionsdarstellung eines erfindungsgemäßen Gehäusesystems in der Draufsicht;
- Fig. 2: das erfindungsgemäße Gehäusesystem in der Draufsicht;
- Fig. 3: eine perspektivische Darstellung des Gehäusesystems nach den Figuren 1 und 2 mit Druckausgleichsfolie;
- Fig. 4: eine perspektivische Darstellung des erfindungsgemäßen Gehäusesystems mit Druckausgleichsfolie bei Normaldruck;
- Fig. 5: eine perspektivische Darstellung des erfindungsgemäßen Gehäusesystems mit Druckausgleichsfolie bei Überdruck;
- Fig. 6: eine perspektivische Darstellung des erfindungsgemäßen Gehäusesystems mit Druckausgleichsfolie bei Unterdruck; und
- Fig. 7: eine perspektivische Darstellung des erfindungsgemäßen Gehäusesystems mit Druckausgleichsfolie in einer Explosionsdarstellung in der Unteransicht.

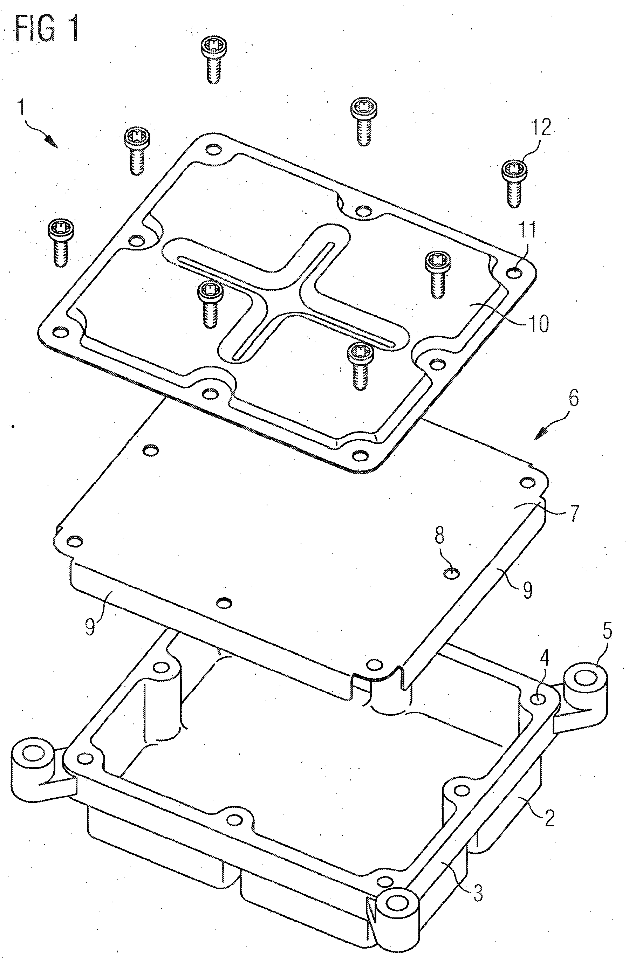

Fig. 1 zeigt in einer Explosionsdarstellung den Aufbau eines erfindungsgemäßen Gehäusesystems 1. Das in Fig. 1 dargestellte Gehäusesystem 1 umfasst ein wannenförmiges Gehäuseunterteil 2 mit vorzugsweise rechteckiger Grundfläche, an dessen Gehäuserand 3, bevorzugt in regelmäßigen Abständen Ausnehmungen 4 angeordnet sind. Jeweils in den Ecken des wannenförmigen Gehäuseunterteils 2 sind, vorzugsweise zylindrische Anschraubaugen 5 angeordnet. Oberhalb des Gehäuseunterteils 2 ist eine Druckausgleichsfolie 6 am Gehäuserand 3 des Gehäuseunterteils 2 befestigt, die eine Grundfläche 7 aufweist, die der Grundfläche des wannenförmigen Gehäuseunterteils 2 entspricht. Diese Druckausgleichsfolie 6 ist vorzugsweise temperaturstabil und elastisch ausgebildet. Positionsgleich zu den Ausnehmungen 4,im Gehäuseunterteil 2 sind in der Druckausgleichsfolie 6 Löcher 8 angeordnet. Jeweils an den Längs- und Querseiten der Druckausgleichsfolie 6 sind Haltelaschen 9 angeordnet, die als zusätzliche Klebeflächen dienen. Diese Haltelaschen 9 sind jeweils in den Ecken der Druckausgleichsfolie 6 durchbrochen. Oberhalb der Druckausgleichsfolie 6 kann ein Schutzdeckel 10 angeordnet sein, der positionsgleich zu den Ausnehmungen 4 des Gehäuseunterteils 2 und zu den Löchern 8 der Druckausgleichsfolie 6 Durchbohrungen 11 aufweist. Über Befestigungsmittel 12 wie zum Beispiel Schrauben, die durch die Durchbohrungen 11 des Schutzdeckels 10 und die Löcher 8 der Druckausgleichsfolie 6 in die Ausnehmungen 4 des Gehäuseunterteils 2 eingeführt werden, kann der Schutzdeckel 10 am Gehäuseunterteil 2 befestigt werden.

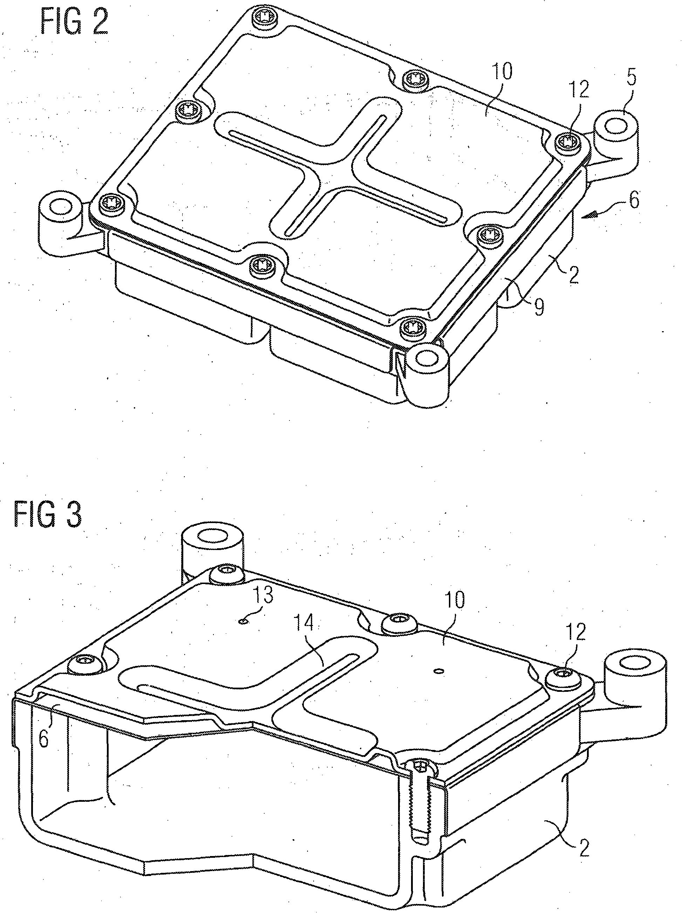

Fig. 2 zeigt eine schematische Darstellung des erfindungsgemäßen Gehäusesystems 1 im verschraubten Zustand. Im verschraubten Zustand sind die Haltelaschen 9 der Druckausgleichsfolie 6 am äußeren Gehäuserand 3 des Gehäuseunterteils 2 befestigt, vorzugsweise verklebt.

Fig. 3 zeigt eine perspektivische Darstellung des erfindungsgemäßen Gehäusesystems 1 mit zusätzlich außenseitig befestigter Druckausgleichsfolie 6, welche als Etikett verwendet werden kann. Der Schutzdeckel 10 weist einen Tiefzug auf, der als Wegbegrenzungselement 14 dient. Des Weiteren weist der Schutzdeckel 10 Druckausgleichsbohrungen 13 auf.

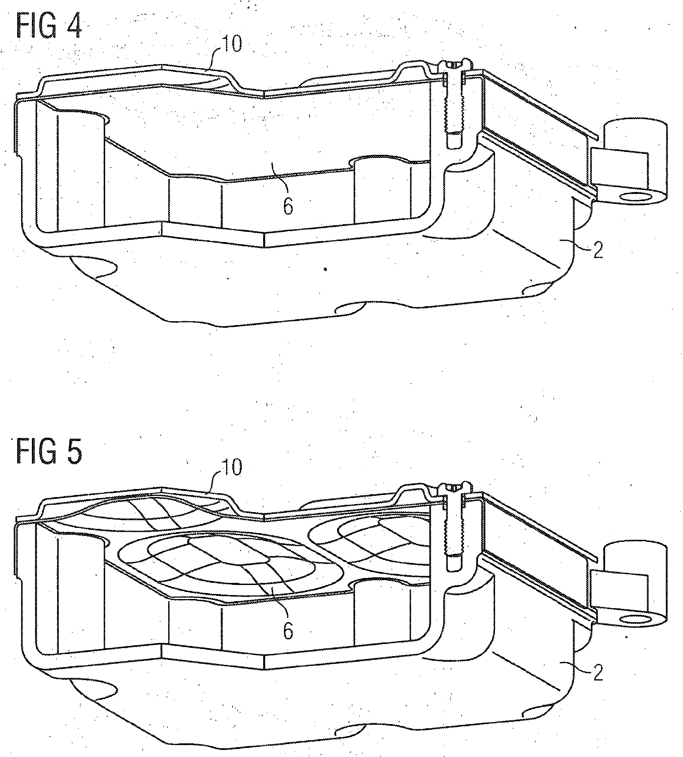

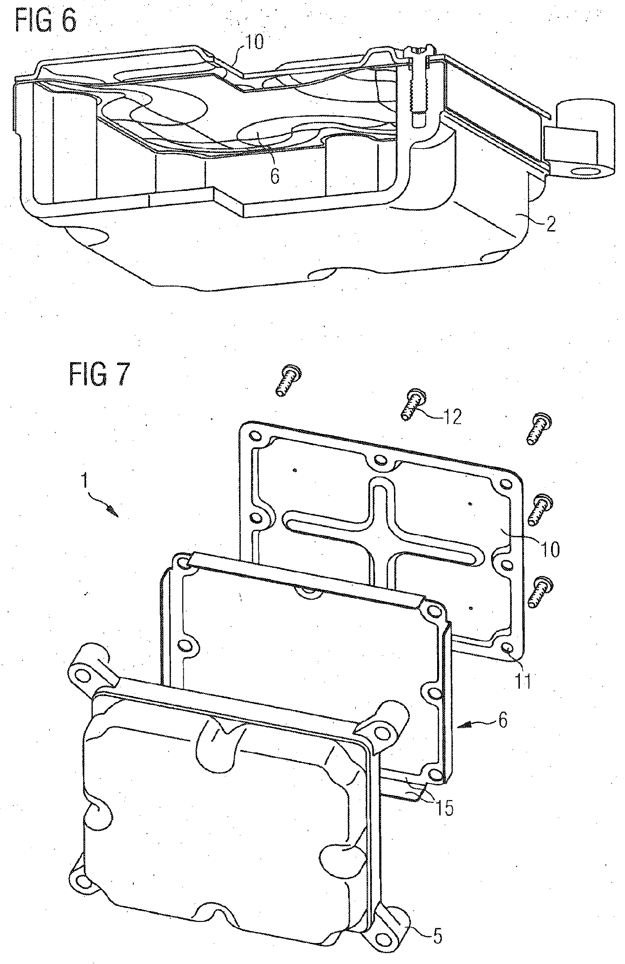

Die Fig. 4 bis 6 zeigen perspektivische Darstellungen des erfindungsgemäßen Gehäusesystems 1 mit der Druckausgleichsfolie 6 bei Normaldruck (Fig. 4), bei Überdruck (Fig. 5) sowie bei Unterdruck (Fig. 6).

Fig. 7 zeigt eine Explosionsdarstellung des erfindungsgemäßen Gehäusesystems von unten, wobei an der Druckausgleichsfolie 6 eine geschlossen umlaufende ringförmige Klebefläche 15 von unten angebracht ist, welche im verklebten Zustand die Dichtfläche darstellt.

Durch das erfindungsgemäße Gehäusesystem ergeben sich folgende Vorteile:
Im Idealfall ersetzt die Druckausgleichsfolie 6 den Gehäusedeckel samt Schrauben, wodurch die Kosten in der Herstellung und der Montage reduziert werden. Des Weiteren wird durch die dichte Verklebung der Folie 6 auf die kostenintensive Dichtung bzw. auf den technisch aufwendigen und qualitativ anspruchsvollen Vergussprozess verzichtet. Das Aufkleben der Folie 6 stellt ein sicheres und leicht umsetzbares Verfahren dar. Es kommt ein abgedichtetes System zum Einsatz, welches die Druckänderungen durch Volumenänderung kompensiert. Die Folienflächendichtung bietet durch die Randflächenverklebung ein einfacheres und kompakteres Dichtsystem im Vergleich zu den nicht besonders platzsparenden Varianten mit Einlege- bzw. Anspritzdichtung oder Verguss aus dem Stand der Technik. Im Vergleich zum Vergießen ist beim Einsatz einer Druckausgleichsfolie 6 eine Reparatur des Gerätes auch außerhalb der Gerätefertigung zum Beispiel in einer Kfz-Werkstatt durch Öffnen und wieder mit neuer Folie Abdichten möglich. Durch die Verklebung besteht eine höhere Toleranz und damit eine geringere Maßgenauigkeit der Gehäusekomponenten. Dieses Dichtsystem-mit der Randflächenverklebung ist durch die Zweidimensionalität insgesamt einfacher umzusetzen als die dreidimensionale Dichtungs- bzw. Vergusstechnik.

Die vorliegende Erfindung schafft erstmals vorteilhaft ein flexibles, individuell und damit variabel auf den Bauraum abstellbares Gehäusesystem mit in einem Druckausgleichselement integriertem Dichtsystem. Sie eignet sich insbesondere für Anwendungen im Automobilbereich.

## Patentansprüche

1. Gehäusesystem (1) für Elektronikgeräte, insbesondere für den Automobilbereich, umfassend ein Gehäuseoberteil (6) sowie ein Gehäuseunterteil (2)mit einem äußeren Gehäuserand (3), wobei am Gehäuseunterteil (2) eine elastische Druckausgleichsfolie (6) als Gehäuseoberteil befestigt ist, **dadurch gekennzeichnet, dass** die Druckausgleichsfolie (6) Haltelaschen (9) aufweist, die am äußeren Gehäuserand (3) des Gehäuseunterteils (2) verklebt sind.

2. Gehäusesystem (1) nach Anspruch 1 oder 2 **dadurch gekennzeichnet, dass** die Druckausgleichsfolie (6) temperaturstabil ist.

3. Gehäusesystem (1) nach einem der vorhergehenden Ansprüche, **dadurch gekennzeichnet, dass** am Rand der Druckausgleichsfolie (6) umlaufend ein geschlossener Klebeflächenring (15) angeordnet ist.

4. Gehäusesystem (1) nach einem der vorhergehenden Ansprüche, **dadurch gekennzeichnet, dass** über der Druckausgleichsfolie (6) ein Schutzdeckel (10) am Gehäuseunterteil (2) befestigt ist.

5. Gehäusesystem (1) nach einem der vorhergehenden Ansprüche, **dadurch gekennzeichnet, dass** die Druckausgleichsfolie (6) durch Begrenzungselemente (14) stabilisiert ist.

## Claims

1. Housing system (1) for electronic devices, in particular for the automobile sector, comprising a housing upper part (6) and a housing lower part (2) with an outer housing edge (3), wherein an elastic pressure equalization film (6) is fastened with the housing upper part to the housing lower part (2), **characterized in that** the pressure equalization film (6) has holding tabs (9) which are adhesively bonded to the outer housing edge (3) of the housing lower part (2).

2. Housing system (1) according to Claim 1 or 2, **characterized in that** the pressure equalization film (6) is thermally stable.

3. Housing system (1) according to either of the preceding claims, **characterized in that** a closed adhesive-surface ring (15) is arranged in an encircling manner on the edge of the pressure equalization film (6).

4. Housing system (1) according to one of the preceding claims, **characterized in that** a protective cover (10) is fastened to the housing lower part (2) above the pressure equalization film (6).

5. Housing system (1) according to one of the preceding claims, **characterized in that** the pressure equalization film (6) is stabilized by boundary elements (14).

## Revendications

1. Système de boîtier (1) destiné à des appareils électroniques, en particulier dans le domaine de l'automobile, comprenant un élément supérieur de boîtier (6) et un élément inférieur de boîtier (2) ayant un bord de boîtier extérieur (3), dans lequel une feuille de compensation de pression élastique (6) est fixée en tant que partie supérieure de boîtier à la partie inférieure de boîtier (2), **caractérisé en ce que** la feuille de compensation de pression (6) présente des pattes de retenue (9) qui sont collées au bord de boîtier extérieur (3) de la partie inférieure de boîtier (2).

2. Système de boîtier (1) selon la revendication 1 ou 2, **caractérisé en ce que** la feuille de compensation de pression (6) est stable en température.

3. Système de boîtier (1) selon l'une quelconque des revendications précédentes, **caractérisé en ce qu'**une bague à surface adhésive fermée (15) est disposée de manière circonférentielle sur le bord de la feuille de compensation de pression (6).

4. Système de boîtier (1) selon l'une quelconque des revendications précédentes, **caractérisé en ce qu'**un couvercle de protection (10) est fixé à la partie inférieure de boîtier (2) sur la feuille de compensation de pression (6).

5. Système de boîtier (1) selon l'une quelconque des revendications précédentes, **caractérisé en ce que** la feuille de compensation de pression (6) est stabilisée par des éléments de limitation (14).
